# EUROPÄISCHE PATENTSCHRIFT

(11) **EP 2 503 669 B1**
(45) Veröffentlichungstag und Bekanntmachung des Hinweises auf die Patenterteilung: **22.01.2020**
(21) Anmeldenummer: 12002058.1
(22) Anmeldetag: 23.03.2012
(51) Int. Cl.: H03K 17/0416, H03K 19/017, H03K 17/042, H03K 17/30

(54) **Sicherheitsgerichtete Automatisierungsanlage mit überwachtem Abschaltverhalten und mit Abschalt-Beschleunigungseinrichtung**
Safety-related automation system with monitored deactivation and with deactivation acceleration device
Système d'automatisation de sécurite avec comportement de commutation contrôlé et avec dispositif d'accélération de commutation

(30) Priorität: 25.03.2011 DE 102011015221
(43) Veröffentlichungstag der Anmeldung: 26.09.2012
(73) Patentinhaber: Phoenix Contact GmbH & Co. KG, 32825 Blomberg (DE)
(72) Erfinder: Oster, Viktor, 32825 Blomberg (DE)
(74) Vertreter: Blumbach · Zinngrebe Patentanwälte PartG mbB

(56) Entgegenhaltungen:
- EP-A1- 2 139 117
- DE-A1- 4 242 792
- DE-T2- 69 324 465
- US-A1- 2003 160 630
- US-A1- 2005 270 068

## Beschreibung

Die Erfindung betrifft eine sicherheitsgerichtete Automatisierungsanlage mit einer Ein- und/oder Ausgabeeinrichung, deren Abschaltverhalten überwacht wird.

In sicherheitsgerichteten Automatisierungsanlagen ist es erforderlich, dass im Fehlerfall die Anlage oder zumindest Teile davon in einen sicheren Zustand gefahren werden können. Insbesondere muss bei einer sicherheitsgerichteten Automatisierungsanlage das sichere Abschalten von Lasten gewährleistet werden. Um das Abschaltverhalten der sicherheitsgerichteten Automatisierungsanlage zu überprüfen, werden in der Regel Abschalt-Testsignale übertragen, mit denen bestimmte Fehler, wie z. B. Querschlüsse in der Verdrahtung zu den angeschlossenen Sensoren und Aktoren erkannt werden können. Aus der US 2003/0160630 A1 ist eine Repeater-Schaltung zum Erfassen und Beschleunigen von Übergangsflanken eines Signals auf einem Bus bekannt, wobei die Übergangsflanken beim Übergang von einem High-Pegel zu einem Low-Pegel und umgekehrt auftreten. Die Repeater-Schaltung weist eine Flanken-Beschleunigungseinrichtung auf, die eine Treiberschaltung mit zwei in Reihe geschalteten Transistoren aufweist. Die Treiberschaltung sorgt dafür, dass bei einem Signalpegelwechsel von Low nach High eine steigende Flanke schnell auf das Potential von VDD und bei einem Signalpegelwechsel von High nach Low eine abfallende Flanke schnell auf Masse gezogen werden kann. Hierzu werden die Transistoren entsprechend leitend beziehungsweise sperrend gehalten, um den Signalpegel beschleunigt auf Masse oder VDD zu ziehen.

Aus der US 2005/0270068 A1 ist ebenfalls ein Flankenbeschleuniger bekannt, bei dem Signallaufzeiten über eine Leitung reduziert werden können, indem Pegelübergänge beschleunigt werden. Bei einem Flankenwechsel von Low nach High wird hierzu ein erster Transistor eingeschaltet, um das Ausgangssignal in einen High-Zustand zu treiben, während bei einem Pegelwechsel von High nach Low'ein zweiter Transistor verwendet wird, um das Ausgangssignal in einen Low-Zustand zu treiben. Sobald der jeweilige Zustand erreicht worden ist, wird der entsprechende Transistor ausgeschaltet, d. h. in den sperrenden Zustand geschaltet.

Der vorliegenden Erfindung liegt die Aufgabe zugrunde, eine sicherheitsgerichtete Automatisierungsanlage zu schaffen, die es ermöglichen, dass eine Ein- und/oder Ausgangseinrichtung mit geringer Verlustleistung und ohne Beeinträchtigung einer möglichen Fehlererkennung in den Zuleitungen zu einer angeschlossenen Last abgeschaltet werden kann.

Ein Kerngedanke der Erfindung kann darin gesehen werden, dass eine Abschalt-Beschleunigungseinrichtung zwischen eine Ein- und/oder Ausgangseinrichtung und eine daran angeschlossene Last geschaltet wird, und zwar ohne Signalentkopplung. Demzufolge können Fehler in der Zuleitung zur Last auch während eines Abschaltvorgangs ohne Beeinträchtigung durch die Abschalt-Beschleunigungseinrichtung erkannt werden. Die Abschalt-Beschleunigungseinrichtung sorgt dafür, dass ein Abschaltsignal am Eingang und/oder am Ausgang der Ein- und Ausgangseinrichtung schnell abfällt, so dass die zeitliche Dauer eines Abschaltvorgangs und die Zeit zum Erkennen einer ordnungsgemäßen Abschaltung verkürzt werden kann.

Das oben genannte technische Problem wird durch die Merkmale der Ansprüche 1, 2 und 3 gelöst.

Der Rahmen der Erfindung wird durch den Schutzumfang der Ansprüche definiert. Der Gegenstand jeglichen Bezugs auf "Ausführungsformen", "Beispiele" oder "Aspekte" der Erfindung in der Beschreibung, welcher nicht unter den Schutzumfang der Ansprüche fällt, sollte lediglich als Illustration oder Beispiel zum besseren Verständnis der Erfindung interpretiert werden.

Danach ist ein gemäß der Erfindung als sicherheitsgerichtete Automatisierungsanlage ausgebildetes Kommunikationssystem vorgesehen, welches eine Ein- und/oder Ausgangseinrichtung enthält. Die Ein- und Ausgangseinrichtung weist wenigstens einen Lastanschluss, einen Masseanschluss sowie eine Überwachungseinrichtung auf, welche dazu ausgebildet ist, während eines Abschaltvorgangs den Spannungsabfall am Lastanschluss zu überwachen. Das Kommunikationssystem weist ferner eine an den Lastanschluss und, je nach Implementierung, gegebenenfalls an den Masseanschluss anschaltbare Last auf. Ferner ist eine Abschalt-Beschleunigungseinrichtung vorgesehen, die dazu ausgebildet ist, einen elektrischen Widerstand zwischen dem Last- und Masseanschluss bereitzustellen, und zwar in Abhängigkeit von der während eines Abschaltvorgangs am Lastanschluss anliegenden Spannung, so dass eine beschleunigte Entladung kapazitiver Elemente erfolgt. Eine Versorgungsspannungsquelle ist vorgesehen, um die Last zu speisen.

Dank dieser Maßnahme ist es möglich, den Abschaltvorgang mit geringer Verlustleistung und beschleunigt durchzuführen.

Angemerkt sei an dieser Stelle, dass es sich bei der Versorgungsspannungsquelle um eine separate Spannungsquelle, welche zum Beispiel nur die Sensoreinrichtung speist, um eine an die Eingangseinrichtung anschaltbare Spannungsquelle oder um eine in der Eingangseinrichtung angeordnete Spannungsquelle handeln kann. Die Eingangseinrichtung kann einen Versorgungsspannungsanschluss aufweisen, an welchem die Versorgungsspannungsquelle anschließbar ist.

Bei dem Kommunikationssystem handelt es sich gemäß der Erfindung um eine sicherheitsgerichtete Automatisierungsanlage. Die Ein- und/oder Ausgabeeinrichtung kann eine Steuereinrichtung, beispielsweise eine speicherprogrammierbare Steuereinrichtung sein. Das Merkmal "kapazitive Elemente" umfasst beispielsweise Leitungskapazitäten der Zuleitung, welche die Ein- und/oder Ausgangseinrichtung mit der Last verbindet, die Kapazität einer kapazitiven Last und/oder eine am Lastanschluss wirkende, systembedingte Kapazität. Angemerkt sei, dass die Überwachungseinrichtung Teil der Abschalt-Beschleunigungseinrichtung sein kann, oder dass die Abschalt-Beschleunigungseinrichtung derart ausgebildet ist, dass sie die Aufgabe der Überwachungseinrichtung übernehmen kann.

Bei einer beispielhaften Ausgestaltung bildet ein passives Widerstandselement mit konstantem Widerstandswert den elektrischen Widerstand. Vorzugsweise weist die Abschalt-Beschleunigungseinrichtung eine Detektoreinrichtung zum Erfassen der Spannung am Lastanschluss, und wenigsten ein mit der Detektoreinrichtung verbundenes Schaltelement auf, das dazu ausgebildet ist, das passive Widerstandelement zwischen den Last- und Masseanschluss zu schalten, wenn die Spannung am Lastanschluss unter einen einstellbaren Schwellwert gefallen ist.

Zweckmäßigerweise ist die Detektoreinrichtung zum Ein- oder Ausschalten des Schaltelements ausgebildet, um im Bedarfsfall die Abschalt-Beschleunigungseinrichtung zu aktivieren bzw. zu deaktivieren.

Anstatt ein passives Widerstandselement mit einem konstanten Widerstandswert zu verwenden, kann ein spannungsabhängiges Widerstandselement verwendet werden, dessen elektrischer Widerstand in Abhängigkeit von der am Lastanschluss anliegenden Spannung veränderbar ist.

Um die Abschalt-Beschleunigungseinrichtung gegen Überlastung zu schützen, ist die Abschalt-Beschleunigungseinrichtung zum Ausschalten des Schaltelements nach einer einstellbaren Zeit ausgebildet. Eine Überlastung kann auftreten, wenn z. B. durch einen Fehler im Kommunikationssystem eine konstante Spannung dauerhaft an der Abschalt-Beschleunigungseinrichtung anliegt, welche unterhalb des einstellbaren Schwellwertes liegt.

Wird die Ein- und/oder Ausgabeeinrichtung als Ausgabegerät betrieben, so stellt der Lastanschluss einen Ausgangsanschluss und die angeschlossene Last einen Aktor, beispielsweise ein Relais oder ein Schütz, dar. In diesem Fall ist die Versorgungsspannungsquelle an den Ausgangsanschluss anschaltbar.

Wird die Ein- und/oder Ausgabeeinrichtung als Eingangsgerät verwendet, so fungiert der Lastanschluss als Eingangsanschluss, während die Last ein Sensor, beispielsweise einen Notausschalter, ist. Die Ein- und/oder Ausgangseinrichtung kann in diesem Fall einen Versorgungsspannungsanschluss aufweisen, an den die Versorgungsspannungsquelle zur Speisung der Last angeschlossen werden kann.

Um einen flexiblen Einsatz des Kommunikationssystems zu ermöglichen, weist die Ein- und/oder Ausgabeeinrichtung wenigstens einen Eingangsanschluss und/oder wenigstens einen Ausgangsanschluss auf.

Die Abschalt-Beschleunigungseinrichtung kann in der Ein- und/oder Ausgabeeinrichtung implementiert sein. Alternativ ist es denkbar, dass die Abschalt-Beschleunigungseinrichtung als Schaltungseinrichtung ausgebildet ist, die extern an die Ein- und Ausgangseinrichtung angeschaltet werden kann.

Denkbar ist ebenfalls, dass die Abschalt-Beschleunigungseinrichtung in einer Klemme oder einer Reihenklemme implementiert ist, welche mit Ein- und/oder Ausgabeeinrichtung verbunden ist.

Zudem kann das Kommunikationssystem, d.h. vorzugsweise die Ein- und Ausgangseinrichtung eine Spannungsdetektoreinrichtung aufweisen, welche zum Erkennen eines Spannungsanstiegs am Lastanschluss ausgebildet ist. Die Abschalt-Beschleunigungseinrichtung kann dann im deaktivierten Zustand gehalten werden, solange ein Spannungsanstieg erkannt wird.

Das oben genannte technische Problem wird ebenfalls durch die Merkmale des Anspruchs 11 gelöst.

Danach ist eine Abschalt-Beschleunigungseinrichtung vorgesehen, welche zum Einsatz in dem zuvor beschriebenen Kommunikationssystem ausgebildet ist.

Die Erfindung wird nachfolgend anhand zweier Ausführungsbeispiele in Verbindung mit den beiliegenden Zeichnungen näher erläutert ist. Es zeigen:
- Fig. 1: ein Kommunikationssystem mit einer Ein- und Ausgangseinrichtung, welche als Eingangsgerät betrieben wird,
- Fig. 2: einen beispielhaften Schaltungsaufbau der in Fig. 1 gezeigten Abschalt-Beschleunigungsschaltung,
- Fig. 3: eine beispielhafte schaltungstechnische Realisierung der in Fig. 2 gezeigten Referenzspannungsschaltung,
- Fig. 4: das in Fig. 1 Kommunikationssystem mit einer Ein- und Ausgangseinrichtung, welche als Ausgangsgerät betrieben wird, und
- Fig. 5: einen beispielhaften Schaltungsaufbau der in Fig. 4 gezeigten Abschalt-Beschleunigungseinrichtung.

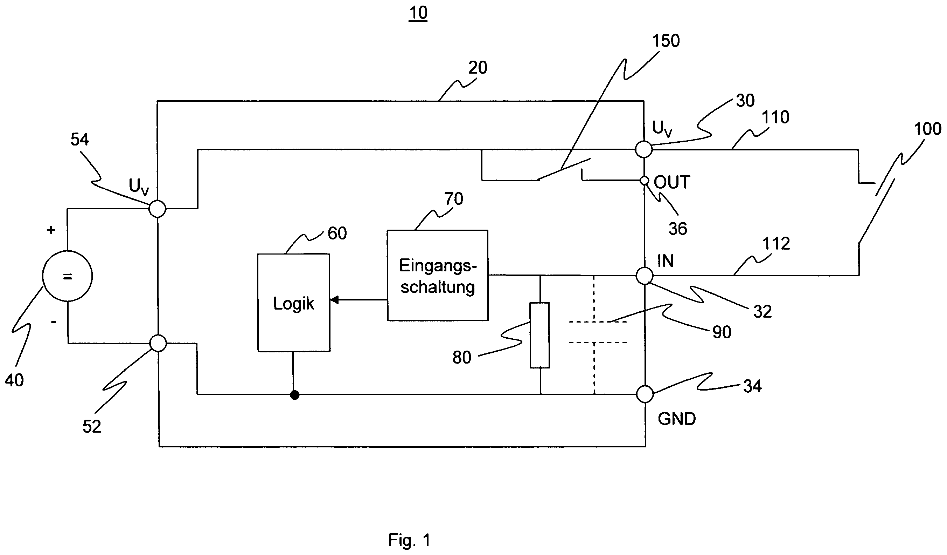

In Fig. 1 ist ein beispielhaftes Kommunikationssystem 10 dargestellt, welches eine Ein- und Ausgangseinrichtung 20 enthält. Das Kommunikationssystem 10 kann im Stand-Alone-Betrieb arbeiten oder Bestandteil einer Automatisierungsanlage sein.

Die Ein- und Ausgangseinrichtung 20 kann über einen Versorgungsspannungsanschluss Uᵥ verfügen, welcher durch das Bezugszeichen 30 gekennzeichnet ist. An dem Versorgungsspannungsanschluss 30 liegt eine Versorgungsspannung Uᵥ an, welche beispielsweise durch eine Gleichspannungsquelle 40 geliefert wird. Die Gleichspannungsquelle 40 kann eine externe Gleichspannungsquelle sein, die an Eingänge 52 und 54 der Ein- und Ausgangseinrichtung 20 angeschlossen ist. Die Gleichspannungsquelle 40 kann auch in der Ein- und Ausgangseinrichtung 20 angeordnet sein. Die Gleichspannungsquelle 40 liefert beispielsweise eine Versorgungsspannung von 25 Volt. Die Ein- und Ausgangseinrichtung 20 verfügt über wenigstens einen Ausgangsanschluss OUT, welcher durch das Bezugszeichen 36 gekennzeichnet ist. Über ein Schaltelement 150 kann die Gleichspannungsquelle 40 zum Betreiben einer Last an den Ausgangsanschluss 36 angelegt werden. Weiterhin weist das Ein- und Ausgabegerät 20 wenigstens einen Eingangsanschluss IN auf, welcher durch das Bezugszeichen 32 gekennzeichnet ist.

Die in Fig. 1 gezeigte Ein- und Ausgangseinrichtung 20 wird als Eingangsgerät betrieben. Demzufolge ist eine Last 100 an dem Versorgungsspannungsanschluss 30 und dem Eingangsanschluss 32 angeschlossen. Die Last 100 ist ein Sensor, welcher im vorliegenden Beispiel ein Notausschalter ist. Angemerkt sei an dieser Stelle, dass das Kommunikationssystem 10 anstelle einer kombinierten Ein- und Ausgangseinrichtung wenigstens ein separates Eingangsgerät und/oder wenigstens ein separates Ausgangsgerät enthalten kann.

Die Ein- und Ausgangseinrichtung 20 weist ferner eine Eingangsschaltung 70 auf, welche mit dem Eingangsanschluss 32 verbunden ist. Die Funktion einer derartigen Eingangsschaltung ist an sich bekannt. Üblicherweise enthält die Eingangsschaltung 70 einen Schwellwertdetektor, der erkennt, ob am Eingangsanschluss 32 eine Spannung anliegt, die beispielsweise größer als 11 Volt ist, oder ob am Eingangsanschluss 32 eine Spannung anliegt, die beispielsweise kleiner als 5 Volt ist. Die Eingangsschaltung 70 ist mit einer Logikeinrichtung 60 verbunden, die wiederum mit dem Masseanschluss 34 der Ein- und Ausgangseinrichtung 20 verbunden ist. Die Logikeinrichtung 60 hat unter anderem die Aufgabe, dem von der Eingangsschaltung 70 erfassten Spannungspegel einen logischen Wert zuzuordnen. Beispielsweise wird jedem Spannungswert, welcher größer oder gleich 11 Volt ist, der logische Wert 1 zugeordnet, während allen Spannungspegeln die kleiner als 5 Volt sind, der logische Wert 0 zugeordnet wird.

Die hinsichtlich des Eingangsanschlusses 32 wirkenden Kapazitäten sind symbolisch durch den gestrichelt gezeichneten Kondensator 90 dargestellt, welcher zwischen dem Eingangsanschluss 32 und dem Masseanschluss 34 wirkt.

Weiterhin weist die Ein- und Ausgangseinrichtung 20 eine Abschalt-Beschleunigungseinrichtung 80 auf, die ebenfalls zwischen den Eingangsanschluss 32 und den Masseanschluss 34 geschaltet ist. Die Abschalt-Beschleunigungseinrichtung 80 kann, wie Fig. 1 zeig in der Ein- und Ausgangseinrichtung 20 implementiert sein. Alternativ kann sie als separate Schaltung extern an die Ein- und Ausgangseinrichtung 20 angeschlossen werden. Denkbar ist auch, dass die Abschalt-Beschleunigungseinrichtung 80 in einer Klemme oder Reihenklemme implementiert ist, an welche die Ein- und Ausgangseinrichtung 20 angeschlossen werden kann.

Bereits an dieser Stelle sei erwähnt, dass eine Aufgabe der Abschalt-Beschleunigungseinrichtung 80 darin besteht, dafür zu sorgen, dass ein Öffnen des Sensors 100 und somit das Abschalten des Eingangsanschlusses 32 von der Gleichspannungsquelle 40 während eines Abschaltvorgangs sicher und schnell erkannt werden kann. Die Funktionsweise der Abschalt-Beschleunigungseinrichtung 80 wird weiter unten noch näher erläutert.

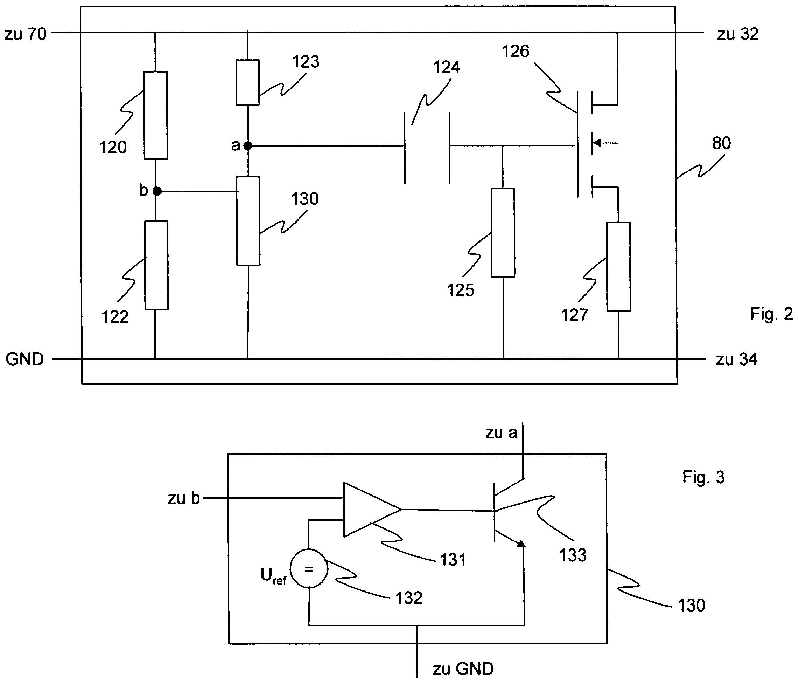

Fig. 2 zeigt eine beispielhafte schaltungstechnische Realisierung der in Fig. 1 gezeigten Abschalt-Beschleunigungseinrichtung 80. Die Abschalt-Beschleunigungseinrichtung 80 weist eine SpannungsDetektoreinrichtung auf, welche einen Spannungsteiler umfasst, der zwei in Reihe geschaltete Widerstände 120 und 122 aufweist. Die Widerstände 120 und 122 des Spannungsteilers sind mit dem Eingangsanschluss 32 und dem Masseanschluss 34 verbunden, wobei ein Anschluss des Widerstandes 120 mit dem Eingangsanschluss 32 und ein Anschluss des Widerstandes 122 mit dem Massenanschluss 34 verbunden ist. Die anderen Anschlüsse der Widerstände 120 und 122 bilden einen gemeinsamen Verbindungspunkt b. An den Eingangsanschluss 32 ist ein Widerstand 123 angeschlossen, welcher mit dem Ausgang einer Referenzspannungsschaltung 130 verbunden ist. Die Referenzspannungsschaltung 130 kann zusammen mit den Widerstände 120 und 122 der Detektoreinrichtung zugeordnet werden. Zudem ist die Referenzspannungsschaltung 130 mit dem Masseanschluss verbunden. Die Referenzspannungsschaltung 130 weist ferner einen Eingang auf, welcher mit der Verbindungsstelle b des Spannungsteilers verbunden ist. Der Ausgang der Referenzspannungsschaltung 130 bildet mit dem Anschluss des Widerstandes 13 einen gemeinsamen Verbindungspunkt a, der über einen Kondensator 124 mit dem Steueranschluss eines Schaltelements 126 verbunden ist. Bei dem Schaltelement 126 kann es sich um einen Feldeffekttransistor handeln. Der Feldeffekttransistor 126 ist beispielsweise ein selbstsperrender n-Mosfet. In diesem Fall ist der Steueranschluss der Gateanschluss des Feldeffekttransistors. Der Gateanschluss des Feldeffekttransistors 126 ist vorzugsweise über einen Widerstand 125 mit dem Masseanschluss 34 verbunden. Der Sourceanschluss des Feldeffekttransistors 126 ist über einen Widerstand 127 mit dem Masseanschluss 34 verbunden. Der Widerstand 127 ist im dargestellten Beispiel ein passiver Widerstand mit einem konstanten Widerstandswert. Der Drainanschluss des Feldeffekttransistors 126 ist mit dem Eingangsanschluss 32 des Ein- und Ausgabegerätes 20 verbunden.

Fig. 3 zeigt eine beispielhafte schaltungstechnische Realisierung der in Fig. 2 gezeigten Referenzspannungsschaltung 130. Die Referenzspannungsschaltung 130 weist einen Komparator 131 auf, dessen einer Eingang mit dem Verbindungspunkt b verbunden ist. Der andere Eingang des Komparators 131 ist an eine Gleichspannungsquelle 132 angeschlossen, die zudem mit dem Masseanschluss 34 verbunden ist. Die Gleichspannungsquelle 132 liefert eine Referenzspannung U_{ref}, die beispielsweise 15 Volt beträgt. Der Ausgang des Komparators 131 ist mit dem Eingang eines Schaltelements 133 verbunden, welcher im vorliegenden Beispiel als bipolarer npn-Transistor ausgebildet ist. Der Ausgang des Komparators 131 ist deshalb mit dem Basisanschluss Transistors 133 verbunden, während der Kollektor des Transistors 133 mit dem Verbindungspunkt a verbunden ist. Der Emitteranschluss des Transistors 133 ist mit dem Masseanschluss 34 verbunden.

Nachfolgend wird die Funktionsweise des beispielhaften Kommunikationssystems 10 anhand der Figuren 1 bis 3 näher erläutert.

Zunächst sei noch einmal erwähnt, dass das Ein- und Ausgabegerät 20 in dem nunmehr beschriebenen Fall als Eingangsgerät betrieben wird.

Angenommen sei ein ordnungsgemäß arbeitender Sensor 100. Solange der Sensor 100, welcher beispielsweise ein Notausschalter ist, geschlossen ist, liegt die Betriebsspannung Uᵥ über den Versorgungsspannungsanschluss 30 und den Notausschalter 100 auch am Eingangsanschluss 32 an. In diesem Zustand ist die Abschalt-Beschleunigungseinrichtung 80 deaktiviert, d.h. der Feldeffekttransistor 126 ist geöffnet bzw. hochohmig. Denn die am Verbindungspunkt b des Spannungsteilers anliegende Spannung, welche proportional zur Spannung am Eingangsanschluss 32 ist, ist größer als die Referenzspannung U_{ref} der Referenzspannungsschaltung 130, d. h. größer als 15 V, so dass der Verbindungspunkt a auf Masse liegt. In diesem Zustand ist der Kondensator 124 entladen, so dass der Feldeffekttransistor 126 der Abschalt-Beschleunigungseinrichtung 80 geöffnet ist.

Die Eingangsschaltung 70 erkennt im ordnungsgemäßen Zustand, dass die Eingangsspannung am Eingangsanschluss 32 größer als der eingestellte Schwellwert von 11 Volt ist, sodass die Logikeinrichtung 60 einen logischen High-Pegel signalisiert.

Die Eingangsschaltung 70 kann derart programmiert sein, dass sie das Öffnen des Sensors 100 beziehungsweise ein Abschaltsignal am Eingangsanschluss 32 erkennt, wenn die Spannung am Eingangsanschluss 32 zum Beispiel kleiner oder gleich 2,5 Volt ist. Aufgrund der Kapazität 90 kann es mehrere Millisekunden dauern, bis die Spannung am Eingangsanschluss 32 auf 2,5 V abgefallen ist. Um einen ordnungsgemäßen Abschaltvorgang am Eingangsanschluss 32 schneller erkennen zu können, ist die Abschalt-Beschleunigungseinrichtung 80 vorgesehen. Sie sorgt dafür, dass während des Abschaltvorgangs die Kapazität 90 am Eingangsanschluss 32 beschleunigt entladen wird. Angemerkt sei an dieser Stelle, dass die Eingangsschaltung 70 Teil der Abschalt-Beschleunigungseinrichtung 80 oder umgekehrt sein kann. Denkbar ist auch, dass die Abschalt-Beschleunigungseinrichtung 80 derart ausgebildet ist, dass sie alle oder nur einige Funktionen der Eingangsschaltung 70 selbst ausführen kann.

Dies wird dadurch erreicht, dass der bezüglich des Eingangsanschlusses 32 und des Masseanschlusses 34 wirkende innere Widerstand, der vornehmlich durch die Eingangsschaltung 70 gebildet wird, vorübergehend verringert wird, so dass die in der Kapazität 90 gespeicherte Ladung schneller abfließen kann.

Wird nunmehr, im Testfall oder im normalen Betrieb, der Notausschalter geöffnet, ist es erforderlich, dass der geöffnete Schaltzustand sicher und möglichst schnell am Eingangsanschluss 32 erkannt werden kann. In Folge der zwischen Eingangsanschluss 32 und Masseanschluss 32 wirkenden Kapazität 90, fällt die Spannung am Eingangsanschluss 32 nicht sprunghaft, sondern exponentiell ab. Dieser Spannungsabfall wird kontinuierlich von den Widerständen 120 und 122 des Spannungsteilers 120 erfasst. Fällt die an der Verbindungsstelle b liegende Spannung, welche auch am Eingang des Komparators 131 anliegt, unter den Wert der Referenzspannung U_{ref} der Spannungsquelle 132, geht der Ausgang des Komparators 131 auf Null, wodurch der Transistor 133 sperrt, die Referenzspannungsschaltung 130 folglich hochohmig wird. Der Verbindungspunkt a zwischen dem Widerstand 123 und der Referenzspannungsschaltung 130 wird somit über den Widerstand 123 auf die am Eingangsanschluss 32 anliegende Spannung gezogen. Dadurch wird der Feldeffekttransistor 126 leitend, sodass der Widerstand 127 zwischen den Eingangsanschluss 32 und den Masseanschluss 34 und parallel zum Innenwiderstand geschaltet wird. Dadurch reduziert sich der hinsichtlich des Eingangsanschlusses 32 und des Masseanschlusses 34 wirkende Innenwiderstand. Als Ergebnis wird die Kapazität 90 beschleunigt entladen und die Spannung am Eingangsanschluss 32 fällt rascher ab. Die Eingangsschaltung 70 erkennt, wann die am Eingangsanschluss 32 anliegende Spannung auf 2,5 Volt abgefallen ist. Dieser Zustand wird von der Eingangsschaltung 70 der Logikeinrichtung 60 signalisiert, die daraufhin ein ordnungsgemäßes Abschalten signalisieren kann.

Die Widerstände 123 und 125 bilden zusammen mit dem Kondensator 124 ein Zeitglied, dessen Dimensionierung eine Zeitkonstante bestimmt, die festlegt, wie lange der Feldeffekttransistor 126 während eines Abschaltvorgangs leitend sein soll. Dadurch kann die Abschalt-Beschleunigungseinrichtung 80 gegen Überlastung geschützt werden, wenn zum Beispiel durch einen fehlerhaften Sensor 100 für einen längeren Zeitraum eine konstante Spannung am Eingangsanschluss 32 anliegt, die unterhalb der Referenzspannung U_{ref} der Spannungsquelle 132 liegt.

An dieser Stelle sei angemerkt, dass zwischen den Verbindungspunkten b und a mehrere Referenzspannungsschaltungen geschaltet sein können, welche bei unterschiedlichen Schwellwerten, d. h. Referenzspannungen, einen hoch- oder niederohmigen Ausgang bilden. Denkbar ist in diesem Zusammenhang, dass jede Referenzspannungsschaltung einen unterschiedlich dimensionierten Entladewiderstand 127 ansteuern kann, sodass der am Eingangsanschluss 32 und Masseanschluss 34 wirkende Innenwiderstand in Abhängigkeit der jeweils eingestellten Referenzspannungsquelle diskret verändert wird.

Denkbar ist ferner, dass der elektrische Widerstand, der durch die Abschalt-Beschleunigungseinrichtung 80 während eines Abschaltvorgangs zwischen den Eingangsanschluss 32 und Masseanschluss 34 bereitgestellt wird, nicht durch den passiven Widerstand 127, sondern durch einen spannungsgesteuerten Widerstand gebildet wird. In diesem Fall kann der am Eingangsanschluss 32 und am Masseanschluss 34 wirkende Innenwiderstand in Abhängigkeit von der am Eingangsanschluss 32 anliegenden Spannung kontinuierlich reduziert werden.

Dank der Maßnahme, dass die Abschalt-Beschleunigungseinrichtung 80 nur während des Abschaltvorgangs aktiv ist, kann die Verlustleistung des Kommunikationssystems 10 reduziert werden. Da die Abschalt-Beschleunigungseinrichtung 80 ferner keine Signalentkopplung benötigt, sondern direkt in die Zuleitung 110, 112 zum Sensor 100 geschaltet ist, können Fehler, z. B. Querschlüsse in der Zuleitung 110, 112 ohne Beeinträchtigung durch die Abschalt-Beschleunigungseinrichtung 80 beispielsweise von der Eingangsschaltung 70 erkannt werden. Hierzu kann die Eingangsschaltung 70 derart ausgebildet sein, dass sie, durch den Beginn eines Abschaltvorgangs getriggert, den Spannungsabfall am Eingangsanschluss 32 überwacht und einen Fehler erfasst, wenn die Spannung am Eingangsanschluss 32 während eines einstellbaren Zeitintervalls nicht auf einen Schwellwert, zum Beispiel 2,5 V , abgefallen ist.

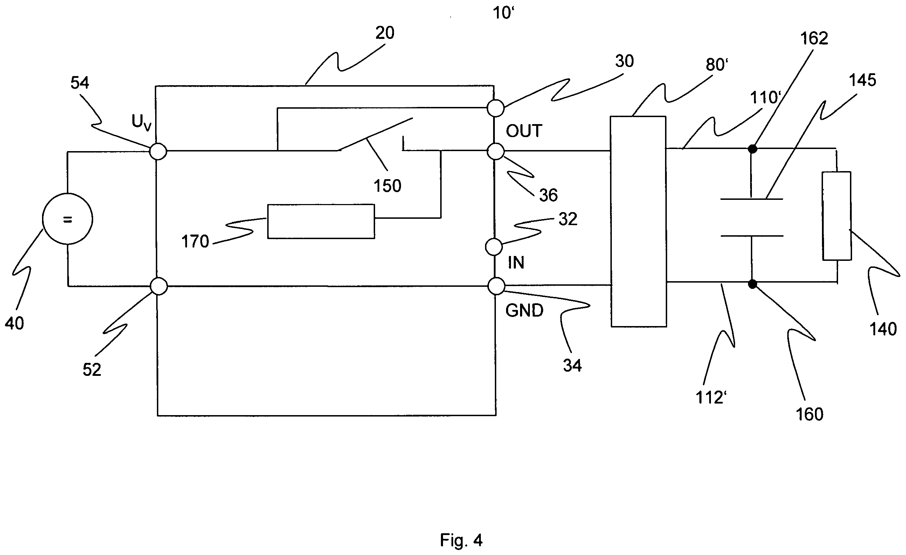

Wir betrachten nunmehr Fig. 4, welche ein Kommunikationssystem 10' zeigt. Das Kommunikationssystem 10' enthält die in Fig. 1 gezeigte Ein- und Ausgangseinrichtung 20, die nunmehr als Ausgangsgerät betrieben wird. Deshalb sind nur die Komponenten der Ein- und Ausgangseinrichtung 20 gezeigt, die für die Funktion als Ausgangsgerät erforderlich sind. Angemerkt sei, dass die Ein- und Ausgangseinrichtung 20 natürlich auch gleichzeitig als Eingangsgerät, wie in Fig. 1 gezeigt, und als Ausgangsgerät, wie in Fig. 4 gezeigt, betrieben werden kann. Gleiche Bezugszeichen bezeichnen deshalb in Fig. 1 und in Fig. 4 gleiche Bauteile.

An den Ausgangsanschluss 36 der Ein- und Ausgangseinrichtung 20 ist über eine Anschlussleitung 110' und 112' eine Last angeschlossen, welche symbolisch durch einen Widerstand 140 und einen parallel dazu geschalteten Kondensator 145 dargestellt ist. Die Last 140, 145 ist ein Aktor, beispielsweise ein Schütz.

Eine externe Abschalt-Beschleunigungseinrichtung 80' ist an den Ausgangsanschluss 36 und den Masseanschluss 34 des Ein- und Ausgabegeräts 20 an Anschlüsse 160 und 162 des Aktors 140, 145 angeschlossen. wie auch in Fig. 1 gezeigt. Die Abschalt- Beschleunigungseinrichtung 80' kann alternativ auch Bestandteil der Ein- und Ausgangseinrichtung 20, einer Klemme oder einer Reihenklemme (nicht dargestellt) sein.

Die Ein- und Ausgangseinrichtung 20 weist eine Spannungsdetektoreinrichtung 170 auf, welche an den Ausgangsanschluss 36 angeschlossen ist. Die Spannungsdetektoreinrichtung 170 kann einen Spannungsanstieg und einen Spannungsabfall am Ausgangsanschluss 36 erkennen. Die Spannungsdetektoreinrichtung 170 oder eine nicht dargestellte Steuereinrichtung der Ein- und Ausgangseinrichtung 20 kann derart ausgebildet sein, dass sie die Abschalt-Beschleunigungseinrichtung 80' deaktiviert, sobald ein Spannungsanstieg am Ausgangsanschluss 36 erkannt worden ist. Alternativ kann die Abschalt-Beschleunigungseinrichtung 80' selbständig einen Spannungsanstieg erkennen. Die Spannungsdetektoreinrichtung 170 kann ebenfalls dazu ausgebildet sein, den Spannungsabfall am Ausgangsanschluss 36 zu überwachen. Erkennt die Spannungsdetektoreinrichtung 170 während eines Abschaltvorgangs, dass die Spannung am Ausgangsanschluss 36 beispielsweise kleiner oder gleich 2,5 Volt ist, schließt sie daraus, dass der Abschaltvorgang erfolgreich ausgeführt worden ist, und keine Fehler, beispielsweise keine Querschlüsse, auf der Anschlussleitung 110' und 112' aufgetreten sind.

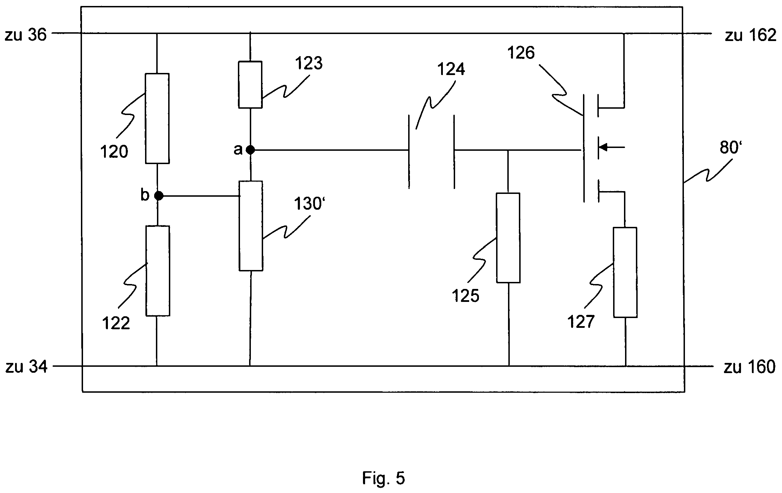

Fig. 5 zeigt eine beispielhafte schaltungstechnische Realisierung der Abschalt-Beschleunigungseinrichtung 80', die der der Abschalt-Beschleunigungseinrichtung 80 nach Fig. 2 mit Ausnahme der Anschlussklemmen entspricht. Die in Fig. 5 gezeigte Referenzspannungsschaltung 130 entspricht wiederum der in Fig. 3 gezeigten Referenzspannungsschaltung 130, so dass sich eine detaillierte Beschreibung erübrigt.

Angemerkt sei an dieser Stelle, dass die Spannungsdetektoreinrichtung 170 Teil der Abschalt-Beschleunigungseinrichtung 80' sein kann.

Die Funktionsweise des in Fig. 4 gezeigten Kommunikationssystems 10' wird nachfolgend näher erläutert.

Wiederum soll das Kommunikationssystem 10' in der Lage sein, einen Abschaltvorgang, gleichgültig ob er in der Testphase oder während der Betriebsphase erfolgt, sicher und schnell zu erkennen.

Zunächst sei angenommen, dass der Schalter 150 geschlossen ist. In diesem Schaltzustand ist der Aktor 140, 145 über den Ausgangsanschluss 36 und den Masseanschluss 34 der Ein- und Ausgangseinrichtung 20 mit der Gleichspannungsquelle 40 verbunden. Solange der Schalter 150 geschlossen ist, liegt die Betriebsspannung Uᵥ am Ausgangsanschluss 36 an. In diesem Zustand ist die Abschalt- Beschleunigungseinrichtung 80' deaktiviert, d.h. der Feldeffekttransistor 126 ist geöffnet bzw. hochohmig. Denn die am Verbindungspunkt b des aus den Widerständen 120 und 122 gebildeten Spannungsteilers anliegende Spannung, welche proportional zur Spannung am Ausgangsanschluss 36 ist, ist größer als die Referenzspannung U_{ref} der Referenzspannungsschaltung 130, d. h. größer als 15 V, so dass der Verbindungspunkt a auf Masse liegt. In diesem Zustand ist der Kondensator 124 entladen, so dass der Feldeffekttransistor 126 der Abschalt-Beschleunigungseinrichtung 80' geöffnet ist. Die Dimensionierung der Bauteile der Abschalt-Beschleunigungseinrichtungen 80 und 80' ist so vorzunehmen, dass ein ordnungsgemäßer Betrieb möglich ist.

Nunmehr sei angenommen, dass ein Abschaltvorgang eingeleitet, d. h. der Aktor 140, 145 abgeschaltet werden soll. Hierzu wird der Schalter 150, wie in Fig. 4 gezeigt, geöffnet, sodass der Ausgangsanschluss 36 nicht mehr mit der Spannungsquelle 40 verbunden ist. In Folge von kapazitiven Elementen, wie zum Beispiel der Kondensator 145 des Aktors und Kapazitäten der Anschlussleitung 110' und 112', fällt die Spannung am Ausgangsanschluss 36 nicht sprunghaft ab, sondern kontinuierlich nach einer e-Funktion, und zwar in Abhängigkeit einer Zeitkonstante, die durch den Kondensator 145 und den Widerstand der Last 140 definiert ist.

Der Spannungsabfall am Ausgangsanschluss 36 wird vom Spannungsteiler 120, 122 der Abschalt-Beschleunigungseinrichtung 80', welche zwischen dem Ausgangsanschluss 36 und Masseanschluss 34 liegt, erfasst. Wiederum sei angenommen, dass die Spannungsquelle 132 der Referenzspannungsschaltung 30 15 Volt beträgt. Fällt während des Abschaltvorgangs die am Ausgangsanschluss 36 anliegende Spannung soweit ab, dass die am Verbindungspunkt b anliegende Spannung, welche auch am Eingang des Komparators 131 anliegt, unterhalb des Schwellwertes, der durch die Referenzspannungsquelle 132 vorgegeben ist, liegt, erzeugt der Komparator 131 an seinem Ausgang eine logische Null und der Schalttransistor 133 wird hochohmig. Demzufolge wird das Potential am Verbindungspunkt a über den Widerstand 123 auf die am Ausgangsanschluss 36 anliegende Spannung gezogen. Hierdurch wird der Feldeffekttransistor 126 leitend geschaltet, so dass der Widerstand 127 parallel zum Widerstand 140 des Aktors geschaltet wird. Diese Maßnahme wirkt wie eine dynamische Reduzierung des Lastwiderstandes 140, so dass die in dem Kondensator 145 und in den Leitungskapazitäten gespeicherte Ladung beschleunigt entladen und somit der erfolgreich abgeschlossene Abschaltvorgang schneller von der Spannungsdetektoreinrichtung 170 erkannt wird. Denn sobald die Spannungsdetektoreinrichtung 170 feststellt, dass die Spannung am Ausgangsanschluss 36 kleiner oder gleich 2,5 Volt ist, wird dies als ordnungsgemäß abgeschlossener Abwahlvorgang interpretiert.

Die Widerstände 123 und 125 bilden zusammen mit dem Kondensator 124 ein Zeitglied, dessen Dimensionierung eine Zeitkonstante bestimmt, die festlegt, wie lange der Feldeffekttransistor 126 während eines Abschaltvorgangs leitend sein soll. Dadurch kann die Abschalt-Beschleunigungseinrichtung 80 gegen Überlastung geschützt werden, wenn zum Beispiel durch einen fehlerhaften Schalter 150 für einen längeren Zeitraum eine konstante Spannung am Ausgangsanschluss 36 anliegt, die unterhalb der Referenzspannung U_{ref} der Spannungsquelle 132 liegt.

An dieser Stelle sei angemerkt, dass zwischen den Verbindungspunkten b und a mehrere Referenzspannungsschaltungen geschaltet sein können, welche bei unterschiedlichen Schwellwerten, d. h. Referenzspannungen, einen hoch- oder niederohmigen Ausgang bilden. Denkbar ist in diesem Zusammenhang, dass jede Referenzspannungsschaltung einen unterschiedlich dimensionierten Entladewiderstand 127 ansteuern kann, sodass der am Ausgangsanschluss 36 und am Masseanschluss 34 wirkende Lastwiderstand in Abhängigkeit der jeweils eingestellten Referenzspannungsquelle diskret verändert wird.

Denkbar ist ferner, dass der elektrische Widerstand, der durch die Abschalt-Beschleunigungseinrichtung 80' während eines Abschaltvorgangs zwischen den Ausgangsanschluss 36 und Masseanschluss 34 bereitgestellt wird, nicht durch den passiven Widerstand 127, sondern durch einen spannungsgesteuerten Widerstand gebildet wird. In diesem Fall kann der Lastwiderstand in Abhängigkeit von der am Ausgangsanschluss 36 anliegenden Spannung kontinuierlich reduziert werden.

Dank der Maßnahme, dass die Abschalt-Beschleunigungseinrichtung 80' nur während des Abschaltvorgangs aktiv ist, kann die Verlustleistung des Kommunikationssystems 10 reduziert werden. Da die Abschalt-Beschleunigungseinrichtung 80' ferner keine Signalentkopplung benötigt, sondern direkt in die Zuleitung 110', 112' zum Aktor 140, 145 geschaltet ist, können Fehler, z. B. Querschlüsse in der Zuleitung 110', 112', ohne Beeinträchtigung durch die Abschalt-Beschleunigungseinrichtung 80' beispielsweise von der Spannungsdetektoreinrichtung 170 erkannt werden. Hierzu kann die Spannungsdetektoreinrichtung 170 derart ausgebildet sein, dass sie, durch den Beginn eines Abschaltvorgangs getriggert, den Spannungsabfall am Ausgangsanschluss 36 überwacht und einen Fehler erfasst, wenn die Spannung am Ausgangsanschluss 36 während eines einstellbaren Zeitintervalls nicht auf einen Schwellwert, zum Beispiel 2,5 V , abgefallen ist.

## Patentansprüche

1. Sicherheitsgerichtete Automatisierungsanlage (10) mit überwachtem Abschaltverhalten aufweisend:
eine Eingabeeinrichtung (20), welche wenigstens einen Eingangsanschluss (32), einen Masseanschluss (34) und eine Überwachungseinrichtung (70) aufweist, welche dazu ausgebildet ist, während eines Abschaltvorgangs den Spannungsabfall am Eingangsanschluss (32) zu überwachen und ein Abschaltsignal eines Sensors (100) am Eingangsanschluss (32) zu erkennen, wenn die Spannung am Eingangsanschluss (32) kleiner oder gleich einem vorbestimmten Spannungswert ist, wobei der Sensor (100) am Eingangsanschluss (32) angeschlossen ist,
eine Versorgungsspannungsquelle (40) zum Speisen des Sensors (100),
eine Abschalt-Beschleunigungseinrichtung (80), die dazu ausgebildet ist, während des Abschaltvorgangs einen elektrischen Widerstand (127) zwischen dem Eingangsanschluss (32) und dem Masseanschluss (36) bereitzustellen, und zwar in Abhängigkeit von der, während des Abschaltvorgangs am Eingangsanschluss (32) anliegenden Spannung, so dass eine beschleunigte Entladung kapazitiver Elemente (90) erfolgt wobei die Abschaltbeschleunigungseinrichtung (80) nur während des Abschaltvorgangs aktiv ist.

2. Sicherheitsgerichtete Automatisierungsanlage (10') mit überwachtem Abschaltverhalten aufweisend:
eine Ausgabeeinrichtung (20), welche wenigstens einen Ausgangsanschluss (36), einen Masseanschluss (34) und eine Überwachungseinrichtung (170) aufweist, welche dazu ausgebildet ist, während eines Abschaltvorgangs den Spannungsabfall am Ausgangsanschluss (36) zu überwachen und eine erfolgreiche Ausführung eines Abschaltvorgangs zu erkennen, wenn die Spannung am Ausgangsanschluss (36) kleiner oder gleich einem vorbestimmten Spannungswert ist,
einen an den Ausgangsanschluss (36) angeschlossenen Aktor (140, 145),
eine Versorgungsspannungsquelle (40) zum Speisen des Aktors (140, 145), wobei die Versorgungsspannungsquelle (40) über einen Schalter (150) mit dem Ausgangsanschluss (36) verbunden ist, eine Abschalt-Beschleunigungseinrichtung (80'), die dazu ausgebildet ist, während des Abschaltvorgangs einen elektrischen Widerstand (127) zwischen dem Ausgangs- und Masseanschluss (34, 36) bereitzustellen, und zwar in Abhängigkeit von der, während des Abschaltvorgangs am Ausgangsanschluss (36) anliegenden Spannung, so dass eine beschleunigte Entladung kapazitiver Elemente (145) erfolgt, wobei die Abschalt-Beschleunigungseinrichtung (80' nur während des Abschaltvorgangs aktiv ist.

3. Sicherheitsgerichtete Automatisierungsanlage (10; 10') mit überwachtem Abschaltverhalten aufweisend:
eine Ein- und Ausgabeeinrichtung (20), welche wenigstens einen Eingangsanschluss (32), wenigstens einen Ausgangsanschluss (36), einen Masseanschluss (34) und eine Überwachungseinrichtung (70; 170) aufweist, welche dazu ausgebildet ist, während eines Abschaltvorgangs den Spannungsabfall am Eingangsanschluss (32) zu überwachen und ein Abschaltsignal eines Sensors (100) am Eingangsanschluss (32) zu erkennen, wenn die Spannung am Eingangsanschluss (32) kleiner oder gleich einem vorbestimmten Spannungswert ist, und während des Abschaltvorgangs den Spannungsabfall am Ausgangsanschluss (36) zu überwachen und eine erfolgreiche Ausführung eines Abschaltvorgangs zu erkennen, wenn die Spannung am Ausgangsanschluss (36) kleiner oder gleich einem vorbestimmten Spannungswert ist, wobei der Sensor (100) am Eingangsanschluss (32) angeschlossen ist, einen an den Ausgangsanschluss (36) angeschlossenen Aktor (140, 145),
eine Versorgungsspannungsquelle (40) zum Speisen des Sensors (100) und des Aktors (140, 145), wobei die Versorgungsspannungsquelle (40) über einen Schalter (150) mit dem Ausgangsanschluss (36) verbunden ist, zwei Abschalt-Beschleunigungseinrichtung (80; 80'), die dazu ausgebildet sind, während des Abschaltvorgangs jeweils einen elektrischen Widerstand (127) zwischen dem Eingangs- und Masseanschluss (32, 34) bzw. zwischen dem Ausgangsanschluss- und Masseanschluss (34, 36) bereitzustellen, und zwar in Abhängigkeit von der, während des Abschaltvorgangs am Eingangsanschluss (32) bzw. am Ausgangsanschluss (36) anliegenden Spannung, so dass eine beschleunigte Entladung kapazitiver Elemente (90; 145) erfolgt, wobei die Abschalt-Beschleunigungseinrichtungen (80, 80') nur während des Abschaltvorgangs aktiv sind.

4. Sicherheitsgerichtete Automatisierungsanlage nach einem der vorstehenden Ansprüche,
**dadurch gekennzeichnet, dass**
ein passives Bauelement (127) mit konstantem Widerstandswert den elektrischen Widerstand bildet und dass jede Abschalt-Beschleunigungseinrichtung (80; 80') folgende Merkmale aufweist:
eine Detektoreinrichtung (120, 122, 130) zum Erfassen der Spannung am Eingangs- oder Ausgangsanschluss (32, 36),
wenigstens ein mit der Detektoreinrichtung (120, 122, 130) verbundenes Schaltelement (126), das dazu ausgebildet ist, den elektrischen Widerstand (127) zwischen den Eingangsanschluss (32) und den Masseanschluss (34) oder den elektrischen Widerstand (127) zwischen den Ausgangsanschluss (36) und den Masseanschluss (34) zu schalten, wenn die Spannung am Eingangsanschluss (32) bzw. am Ausgangsanschluss (36) unter einen Schwellwert gefallen ist.

5. Sicherheitsgerichtete Automatisierungsanlage nach Anspruch 4,
**dadurch gekennzeichnet, dass**
die Detektoreinrichtung (120, 122, 130) zum Ein- oder Ausschalten des Schaltelements (126) ausgebildet ist.

6. Sicherheitsgerichtete Automatisierungsanlage nach einem der Ansprüche 1 bis 3,
**dadurch gekennzeichnet, dass**
ein spannungsabhängiges Widerstandselement vorgesehen ist, dessen elektrischer Widerstand in Abhängigkeit von der am Eingangs- bzw. Ausgangsanschluss (32, 36) anliegenden Spannung veränderbar ist.

7. Sicherheitsgerichtete Automatisierungsanlage nach Anspruch 4 oder 5,
**dadurch gekennzeichnet, dass**
die Abschalt-Beschleunigungseinrichtung (80; 80') zum Ausschalten des Schaltelements (126) nach einer einstellbaren Zeit ausgebildet ist.

8. Sicherheitsgerichtete Automatisierungsanlage nach Anspruch 2 oder 3,
**dadurch gekennzeichnet, dass**
die Versorgungsspannungsquelle (40) an den Ausgangsanschluss (36) an- und abschaltbar ist.

9. Sicherheitsgerichtete Automatisierungsanlage nach Anspruch 1 oder 3,
**dadurch gekennzeichnet, dass**
die Eingabeeinrichtung oder die Ein- und Ausgabeeinrichtung (20) einen Versorgungsspannungsanschluss (30) aufweisen kann, an welchen die Versorgungsspannungsquelle (40) anschaltbar ist.

10. Sicherheitsgerichtete Automatisierungsanlage nach einem der vorstehenden Ansprüche,
**dadurch gekennzeichnet, dass**
die Ein- und/oder Ausgabeeinrichtung eine speicherprogrammierbare Steuereinrichtung ist.

11. Sicherheitsgerichete Automatisierungsanlage nach einem der vorstehenden Ansprüche,
**dadurch gekennzeichnet, dass**
die Abschalt-Beschleunigungseinrichtung (80; 80') in der Eingabeeinrichtung, der Ausgabeeinrichtung oder der Eingabe- und Ausgabeeinrichtung implementiert oder als anschaltbare Schaltungseinrichtung ausgebildet ist.

12. Sicherheitsgerichtete Automatisierungsanlage nach einem der vorstehenden Ansprüche,
**gekennzeichnet durch**
eine Spannungsdetektoreinrichtung (70), welche zum Erkennen eines Spannungsanstiegs am Eingangsanschluss (32) ausgebildet ist, wobei die Abschalt-Beschleunigungseinrichtung (80) unter Ansprechen auf einen erkannten Spannungsanstieg am Eingangsanschluss (32) deaktiviert wird, und/oder
eine Spannungsdetektoreinrichtung (170), welche zum Erkennen eines Spannungsanstiegs am Ausgangsanschluss (36) ausgebildet ist, wobei die Abschalt-Beschleunigungseinrichtung (80') unter Ansprechen auf einen erkannten Spannungsanstieg am Ausgangsanschluss (36) deaktiviert wird.

13. Sicherheitsgerichtete Automatisierungsanlage nach einem der vorstehenden Ansprüche,
**dadurch gekennzeichnet, dass**
die Überwachungseinrichtung (70, 170) Teil der Abschalt-Beschleunigungseinrichtung (80; 80') ist.

## Claims

1. A safety-related automation system (10) with monitored deactivation behavior, comprising:
an input device (20) having at least one input connection (32), a ground connection (34) and
a monitoring device (70) which is adapted to monitor the voltage drop at the input connection (32) during a deactivation operation and to detect a deactivation signal of a sensor (100) at the input connection (32) when the voltage at the input connection (32) is less than or equal to a predetermined voltage value, wherein the sensor (100) is connected to the input connection (32);
a voltage supply source (40) for powering the sensor (100);
a deactivation acceleration device (80) which is adapted to provide an electrical resistor (127) between the input connection (32) and the ground connection (34) during the deactivation operation in dependence of the voltage applied at the input connection (32) during the deactivation operation, so that accelerated discharge of capacitive elements (90) occurs, wherein the deactivation acceleration device (80) is active only during the deactivation operation.

2. A safety-related automation system (10') with monitored deactivation behavior, comprising:
an output device (20) having at least one output connection (36), a ground connection (34) and a monitoring device (170) which is adapted to monitor the voltage drop at the output connection (36) during a deactivation operation and to detect successful execution of a deactivation operation when the voltage at the output connection (36) is less than or equal to a predetermined voltage value;
an actuator (140, 145) connected to the output connection (36);
a voltage supply source (40) for powering the actuator (140, 145), the voltage supply source (40) being connected to the output connection (36) via a switch (150);
a deactivation acceleration device (80') which is adapted to provide an electrical resistor (127) between the output and ground connections (36, 34) during the deactivation operation in dependence of the voltage applied at the output connection (36) during the deactivation operation, so that accelerated discharge of capacitive elements (145) occurs, wherein the deactivation acceleration device (80') is active only during the deactivation operation.

3. The safety-related automation system (10, 10') with monitored deactivation behavior, comprising:
an input and output device (20) having at least one input connection (32), at least one output connection (36), a ground connection (34) and a monitoring device (70; 170), which is adapted to monitor the voltage drop at the input connection (32) during a deactivation operation and to detect a deactivation signal of a sensor (100) at the input connection (32) when the voltage at the input connection (32) is less than or equal to a predetermined voltage value, and to monitor the voltage drop at the output connection (36) during the deactivation operation and to detect successful execution of a deactivation operation when the voltage at the output connection (36) is less than or equal to a predetermined voltage value, wherein the sensor (100) is connected to the input connection (32);
an actuator (140, 145) connected to the output connection (36);
a voltage supply source (40) for powering the sensor (100) and the actuator (140, 145), the voltage supply source (40) being connected to the output connection (36) via a switch (150);
two deactivation acceleration devices (80; 80') which are adapted to provide a respective electrical resistor (127) between the input and ground connections (32, 34) and between the output and ground connections (36, 34) during the deactivation operation as a function of the voltage applied at the input connection (32) and at the output connection (36), respectively, during the deactivation operation, so that accelerated discharge of capacitive elements (90; 145) occurs, wherein the deactivation acceleration devices (80; 80') are active only during the deactivation operation.

4. The safety-related automation systems according to any one of the preceding claims, **characterized in that** a passive component (127) with a constant resistance value forms the electrical resistor; and that each deactivation acceleration device (80; 80') has the following features:
a detector device (120, 122, 130) for detecting the voltage at the input or output connection (32, 36);
at least one switching element (126) connected to the detector device (120, 122, 130) and adapted to connect the electrical resistor (127) between the input connection (32) and the ground connection (34) or to connect the electrical resistor (127) between the output connection (36) and the ground connection (34) when the voltage at the input connection (32) or at the output connection (36) has dropped below a threshold value.

5. The safety-related automation system according to claim 4, **characterized in that**
the detector device (120, 122, 130) is adapted to switch on or off the switching element (126).

6. The safety-related automation system according to any one of claims 1 to 3,
**characterized in that**
a voltage-dependent resistor element is provided, which has an electrical resistance that is variable in dependence of the voltage applied at the input or output connection (32, 36).

7. The safety-related automation system according to claim 4 or 5, **characterized in that**
the deactivation acceleration device (80; 80') is adapted to switch off the switching element (126) after an adjustable time.

8. The safety-related automation system according to claim 2 or 3, **characterized in that**
the voltage supply source (40) can be connected to and disconnected from the output connection (36).

9. The safety-related automation system according to claim 1 or 3, **characterized in that**
the input device or the input and output devices (20) can have a voltage supply port (30) to which the voltage supply source (40) is connectable.

10. The safety-related automation system according to any one of the preceding claims, **characterized in that**
the input and/or output device is a programmable logic controller.

11. The safety-related automation system according to any one of the preceding claims, **characterized in that**
the deactivation acceleration device (80; 80') is implemented in the input device or in the output device or in the input and output devices or is configured as connectable circuit device.

12. The safety-related automation system according to any one of the preceding claims, **characterized by**
a voltage detector device (70) adapted to detect a voltage rise at the input connection (32), wherein the deactivation acceleration device (80) is disabled in response to a detected voltage rise at the input connection (32); and/or
a voltage detector device (170) adapted to detect a voltage rise at the output connection (36), wherein the deactivation acceleration device (80') is disabled in response to a detected voltage rise at the output connection (36).

13. The safety-related automation system according to any one of the preceding claims, **characterized in that**
the monitoring device (70, 170) forms part of the deactivation acceleration device (80; 80').

## Revendications

1. Installation d'automatisation sécurisée (10) à comportement de mise à l'arrêt surveillé présentant :
un dispositif d'entrée (20), lequel présente au moins une borne d'entrée (32), une connexion à la masse (34) et un dispositif de surveillance (70), lequel est conçu pour surveiller la chute de tension au niveau de la borne d'entrée (32) pendant un processus de mise à l'arrêt et repérer un signal de mise à l'arrêt d'un capteur (100) au niveau de la borne d'entrée (32), lorsque la tension au niveau de la borne d'entrée (32) est inférieure ou égale à une valeur de tension prédéfinie, où le capteur (100) est raccordé à la borne d'entrée (32),
une source de tension d'alimentation (40) destinée à alimenter le capteur (100),
un dispositif d'accélération de mise à l'arrêt (80), qui est conçu pour fournir une résistance électrique (127) entre la borne d'entrée (32) et la connexion à la masse (34) pendant le processus de mise à l'arrêt, et ce en fonction de la tension s'appliquant à la borne d'entrée (32) pendant le processus de mise à l'arrêt, de sorte qu'une décharge accélérée d'éléments capacitifs (90) s'effectue, où le dispositif d'accélération de mise à l'arrêt (80) n'est actif que pendant le processus de mise à l'arrêt.

2. Installation d'automatisation sécurisée (10') à comportement de mise à l'arrêt surveillé présentant :
un dispositif de sortie (20), lequel présente au moins une borne de sortie (36), une connexion à la masse (34) et un dispositif de surveillance (170), lequel est conçu pour surveiller la chute de tension au niveau de la borne de sortie (36) pendant un processus de mise à l'arrêt et repérer une réalisation réussie d'un processus de mise à l'arrêt lorsque la tension au niveau de la borne de sortie (36) est inférieure ou égale à une valeur de tension prédéfinie,
un actionneur (140, 145) raccordé à la borne de sortie (36),
une source de tension d'alimentation (40) destinée à alimenter l'actionneur (140, 145), où la source de tension d'alimentation (40) est reliée à la borne de sortie (36) par l'intermédiaire d'un commutateur (150),
un dispositif d'accélération de mise à l'arrêt (80'), qui est conçu pour fournir une résistance électrique (127) entre la borne de sortie et la connexion à la masse (36, 34) pendant le processus de mise à l'arrêt, et ce en fonction de la tension s'appliquant à la borne de sortie (36) pendant le processus de mise à l'arrêt, de sorte qu'une décharge accélérée d'éléments capacitifs (145) s'effectue, où le dispositif d'accélération de mise à l'arrêt (80') n'est actif que pendant le processus de mise à l'arrêt.

3. Installation d'automatisation sécurisée (10 ; 10') à comportement de mise à l'arrêt surveillé présentant :
un dispositif d'entrée et de sortie (20), lequel présente au moins une borne d'entrée (32), au moins une borne de sortie (36), une connexion à la masse (34) et un dispositif de surveillance (70 ; 170), lequel est conçu pour surveiller la chute de tension au niveau de la borne d'entrée (32) pendant un processus de mise à l'arrêt et repérer un signal de mise à l'arrêt d'un capteur (100) au niveau de la borne d'entrée (32), lorsque la tension au niveau de la borne d'entrée (32) est inférieure ou égale à une valeur de tension prédéfinie, et surveiller la chute de tension au niveau de la borne de sortie (36) pendant le processus de mise à l'arrêt et repérer une réalisation réussie d'un processus de mise à l'arrêt, lorsque la tension au niveau de la borne de sortie (36) est inférieure ou égale à une valeur de tension prédéfinie, où le capteur (100) est raccordé à la borne d'entrée (32), un actionneur (140, 145) raccordé à la borne de sortie (36),
une source de tension d'alimentation (40) destinée à alimenter le capteur (100) et l'actionneur (140, 145), où la source de tension d'alimentation (40) est reliée à la borne de sortie (36) par l'intermédiaire d'un commutateur (150),
deux dispositifs d'accélération de mise à l'arrêt (80 ; 80'), qui sont conçus pour fournir respectivement une résistance électrique (127) entre la borne d'entrée et la connexion à la masse (32, 34) ou entre la borne de sortie et la connexion à la masse (36, 34) pendant le processus de mise à l'arrêt, et ce en fonction de la tension s'appliquant à la borne d'entrée (32) ou à la borne de sortie (36) pendant le processus de mise à l'arrêt, de sorte qu'une décharge accélérée d'éléments capacitifs (90 ; 145) s'effectue, où les dispositifs d'accélération de mise à l'arrêt (80, 80') ne sont actifs que pendant le processus de mise à l'arrêt.

4. Installation d'automatisation sécurisée selon l'une quelconque des revendications précédentes,
**caractérisée en ce que**
un composant passif (127) à résistance constante forme la résistance électrique et
**en ce que** chaque dispositif d'accélération de mise à l'arrêt (80 ; 80') présente les caractéristiques suivantes :
un dispositif de détection (120, 122, 130) destiné à détecter la tension au niveau de la borne d'entrée ou de sortie (32, 36),
au moins un élément de commutation (126) relié au dispositif de détection (120, 122, 130), qui est conçu pour commuter la résistance électrique (127) entre la borne d'entrée (32) et la connexion à la masse (34) ou la résistance électrique (127) entre la borne de sortie (36) et la connexion à la masse (34), lorsque la tension au niveau de la borne d'entrée (32) ou au niveau de la borne de sortie (36) a chuté au-dessous d'une valeur seuil.

5. Installation d'automatisation sécurisée selon la revendication 4, **caractérisée en ce que**
le dispositif de détection (120, 122, 130) est conçu pour la mise en service ou hors service de l'élément de commutation (126).

6. Installation d'automatisation sécurisée selon l'une quelconque des revendications 1 à 3, **caractérisée en ce que**
un élément de résistance dépendant de la tension est prévu, dont la résistance électrique peut être modifiée en fonction de la tension s'appliquant à la borne d'entrée ou de sortie (32, 36).

7. Installation d'automatisation sécurisée selon la revendication 4 ou 5, **caractérisée en ce que**
le dispositif d'accélération de mise à l'arrêt (80 ; 80') est conçu pour mettre hors service l'élément de commutation (126) après un temps réglable.

8. Installation d'automatisation sécurisée selon la revendication 2 ou 3, **caractérisée en ce que**
la source de tension d'alimentation (40) au niveau de la borne de sortie (36) peut être mise en marche et à l'arrêt.

9. Installation d'automatisation sécurisée selon la revendication 1 ou 3, **caractérisée en ce que**
le dispositif d'entrée ou le dispositif d'entrée et de sortie (20) peut présenter une borne de tension d'alimentation (30), au niveau de laquelle la source de tension d'alimentation (40) peut être mise en marche.

10. Installation d'automatisation sécurisée selon l'une quelconque des revendications précédentes, **caractérisée en ce que**
le dispositif d'entrée et/ou de sortie est un automate programmable industriel.

11. Installation d'automatisation sécurisée selon l'une quelconque des revendications précédentes, **caractérisée en ce que**
le dispositif d'accélération de mise à l'arrêt (80 ; 80') est implémenté dans le dispositif d'entrée, le dispositif de sortie ou le dispositif d'entrée et de sortie ou est réalisé sous la forme d'un dispositif de commutation pouvant être mis en marche.

12. Installation d'automatisation sécurisée selon l'une quelconque des revendications précédentes, **caractérisée par**
un dispositif de détection de tension (70), lequel est conçu pour repérer une hausse de tension au niveau de la borne d'entrée (32), où le dispositif d'accélération de mise à l'arrêt (80) est désactivé en réponse à une hausse de tension repérée au niveau de la borne d'entrée (32), et/ou
un dispositif de détection de tension (170), lequel est conçu pour repérer une hausse de tension au niveau de la borne de sortie (36), où le dispositif d'accélération de mise à l'arrêt (80') est désactivé en réponse à une hausse de tension repérée au niveau de la borne de sortie (36).

13. Installation d'automatisation sécurisée selon l'une quelconque des revendications précédentes, **caractérisée en ce que**
le dispositif de surveillance (70, 170) fait partie du dispositif d'accélération de mise à l'arrêt (80 ; 80').
